(19) Europäisches Patentamt

European Patent Office

Office européen des brevets

(11) **EP 0 696 652 A2**

(12) **EUROPÄISCHE PATENTANMELDUNG**

(43) Veröffentlichungstag:
**14.02.1996 Patentblatt 1996/07**

(51) Int. Cl.⁶: **C30B 15/00**, C30B 13/00,
C30B 29/06

(21) Anmeldenummer: 95112274.6

(22) Anmeldetag: **04.08.1995**

(84) Benannte Vertragsstaaten:
**DE FR GB IT**

(30) Priorität: **13.08.1994 DE 4428743**

(71) Anmelder: **Müller, Georg, Prof. Dr.**
**D-91094 Langensendelbach (DE)**

(72) Erfinder:
• **Müller, Georg, Prof. Dr.**
**D-91094 Langensendelbach (DE)**
• **Marten, Rainer, Dipl. Ing.**
**D-91058 Erlangen (DE)**
• **Seidl, Albrecht, Dipl. Ing.**
**D-91056 Erlangen (DE)**

(74) Vertreter: **Rau, Manfred, Dr. Dipl.-Ing.**
**D-90402 Nürnberg (DE)**

(54) **Verfahren und Vorrichtung zur Messung und Steuerung bzw. Regelung der Sauerstoffkonzentration in Siliciumschmelzen**

(57) Bei einem Verfahren zur Messung und Regelung der Sauerstoffkonzentration in Siliciumschmelzen, welche sich in einem SiO₂-Glastiegel befinden oder mit einer SiO₂-Glasoberfläche in Kontakt bringbar sind, ist insbesondere zur Erzielung einer definierten, homogenen axialen Sauerstoffkonzentration in dem wachsenden Kristall vorgesehen, daß die Messung der Sauerstoffkonzentration durch eine in die Schmelze eintauchende elektrochemische Potentialsonde erfolgt, wobei das Potential zwischen dem wachsenden Siliciumkristall und der Sonde abgegriffen wird und durch Anlegen einer Spannung zwischen Kristall und SiO₂-Tiegel der Sauerstoffgehalt in der Schmelze bzw. im Kristall gesteuert bzw. geregelt werden kann.

Eine Vorrichtung zur Durchführung des Verfahrens zeichnet sich dadurch aus, daß eine elektrochemische Potential-Sonde (1o) aus einem ein Metall/Metalloxid-Gemisch einschließenden, abgeschlossenen SiO₂-Glasröhrchen (1) gebildet ist, welches mit einem Metalldraht (3) kontaktiert ist.

Fig. 1

EP 0 696 652 A2

**Beschreibung**

Die Erfindung richtet sich auf ein Verfahren und eine Vorrichtung zur Messung und Steuerung bzw. Regelung der Sauerstoffkonzentration in Siliciumschmelzen, insbesondere im Zusammenhang mit der Herstellung von Silicium-Einkristallen nach dem Czochralski-Verfahren. Ein derartiges Verfahren ist aus der EP o 425 837 A1 bekannt.

Der Sauerstoffgehalt in Silicium-Einkristallen beeinflußt entscheidend die elektrischen und mechanischen Eigenschaften des Materials. So ist z.B. für die Anwendung in der Mikroelektronik ein ausreichend hoher, jedoch nicht zu hoher Sauerstoffgehalt erforderlich, um Ausscheidungen metallischer Restverunreinigungen an sauerstoff-induzierten Defekten im Inneren der Siliciumscheiben zu ermöglichen, welche zu einer besonders reinen Oberflächenschicht führen (das sogenannte "intrinsische Gettern").

Das zur Herstellung von Silicium-Einkristallen überwiegend eingesetzte Czochralski-Verfahren, d.h. das Ziehen von Einkristallen aus der Schmelze, führt jedoch zu einer mehr oder weniger ausgeprägt inhomogenen axialen und lateralen Sauerstoffverteilung in den Kristallen, da sich während des Prozesses die thermischen Bedingungen ständig ändern, welche die Auflösung des die Siliciumschmelze enthaltenden SiO$_2$-Glastiegels beeinflussen. Derzeit wird der Sauerstoffgehalt der Schmelze durch eine spezielle Führung des Inertgasstromes über der Schmelzen-Oberfläche gesteuert oder über die Kristall- und Tiegelrotation. Dabei wird in erster Linie eine Herabsetzung der Sauerstoffkonzentration in der Schmelze angestrebt. Eine nicht-verunreinigende insitu-Messung der Sauerstoffkonzentration in der Schmelze ist bisher nicht möglich, so daß mangels entsprechender Meßwerte auch eine Regelung nicht durchführbar ist. Dies gilt entsprechend auch für alle anderen Verfahren zur Herstellung von Silicium-Einkristallen, z.B. für das tiegelfreie Zonenziehen.

Hiervon ausgehend liegt der Erfindung die Aufgabe zugrunde, ein Verfahren und eine Vorrichtung anzugeben, womit die Sauerstoffkonzentration in der Schmelze und in dem wachsenden Kristall diese nicht verunreinigt gemessen und gesteuert bzw. geregelt werden kann. Insbesondere soll die Herstellung von Kristallen mit definierter, homogener axialer Sauerstoffkonzentration ermöglicht werden.

Diese Aufgabe wird bei dem Verfahren der eingangs genannten Art dadurch gelöst, daß die Messung der Sauerstoffkonzentration durch eine in die Schmelze eintauchende elektrochemische Potentialsonde erfolgt, wobei das Potential zwischen dem wachsenden Siliciumkristall und der Sonde abgegriffen wird.

In weiterer Ausgestaltung der Erfindung ist vorgesehen, daß eine Steuerung der Sauerstoffkonzentration in der Schmelze durch Anlegen einer Steuerspannung zwischen dem außen kontaktierten SiO$_2$-Glastiegel bzw. einem außen kontaktierten, die Schmelze berührenden SiO$_2$-Glas und dem wachsenden Siliciumkristall bewerkstelligt wird.

Günstigerweise kann durch einen Vergleich des gemessenen Potentials zwischen dem wachsenden Siliciumkristall und der Sonde mit einem Sollwert und durch Anlegen einer Steuerspannung zur Korrektur einer gegebenenfalls gemessenen Abweichung vom Sollwert eine Regelung des Sauerstoffgehaltes der Schmelze bzw. des aus der Schmelze wachsenden Kristalls erreicht werden.

Dabei macht man sich die Eigenschaft zunutze, daß etwa so viel Sauerstoff in den Kristall eingebaut wird, wie in der Schmelze an der Wachstumsgrenzfläche vorliegt.

Von zentraler Bedeutung für die Erfindung ist also die Ausnutzung der sauerstoffleitenden Eigenschaften von SiO$_2$-Glas bei hohen Temperaturen über 1ooo°C. Die erfindungsgemäße Vorgehensweise ermöglicht es erstmals, die Sauerstoffkonzentration in der Schmelze zu messen und zu steuern bzw. zu regeln und damit letztendlich auch die Sauerstoffkonzentration in dem aus der Schmelze wachsenden Kristall, so daß Kristalle mit einer homogenen Verteilung der Sauerstoffkonzentration in axialer Richtung erzielbar sind.

Nachfolgend wird die Erfindung anhand eines bevorzugten Ausführungsbeispiels in Verbindung mit der Zeichnung näher beschrieben. Dabei zeigen:

Fig. 1    eine schematische Darstellung einer erfindungsgemäßen Sonde, die in eine Schmelze eintaucht,

Fig. 2    eine schematische Darstellung der erfindungsgemäßen Anordnung zur Steuerung des Sauerstoffgehaltes in der Schmelze beim Czochralski-Verfahren und

Fig. 3    eine schematische Darstellung der Anwendung des erfindungsgemäßen Verfahrens beim tiegelfreien Zonenziehen von Silicium.

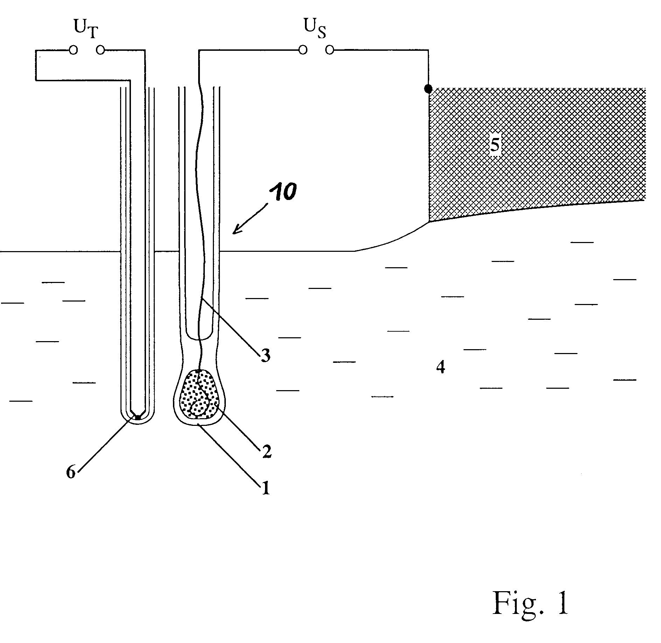

Bei der in Fig. 1 dargestellten Anordnung ist in einem abgeschmolzenen Röhrchen 1 aus SiO$_2$-Glas ("Quarzglas") ein Metall/Metalloxid-Gemisch 2 (z.B. Cr/Cr$_2$O$_3$) eingeschlossen, welches in der Kammer einen definierten, temperaturabhängigen Sauerstoff-Referenzpartialdruck p$_r$ erzeugt. Das Metall/Metalloxidgemisch wird über einen Draht 3 kontaktiert. Die Schmelze 4 wird über den wachsenden Kristall 5 kontaktiert. Die Temperatur wird mit einem unmittelbar benachbarten, von einem SiO$_2$-Glasröhrchen geschützten Thermoelement 6 gemessen. Das Thermoelement 6 kann auch innerhalb des Metall/Metalloxidgemisches 2 bzw. innerhalb des SiO$_2$-Glasröhrchens 1 integriert werden. Zwischen Kristall 5 und Kontaktdraht 3 wird die Sondenspannung U$_S$ gemessen und am Thermoelement die Thermospannung U$_T$, aus der sich die Temperatur T der Schmelze berechnet. Der Sauerstoffgehalt bzw. Molenbruch n$_O$ in der Schmelze berechnet sich dann näherungsweise aus der Beziehung

$$n_O \approx p_r^{1/2} \cdot \exp\left(\frac{-2UF - \Delta G^0}{RT}\right)$$

mit der Sondenspannung U, der Faraday-Konstanten F, der Gaskonstanten R, der Temperatur T, dem Referenz-Sauerstoffpartialdruck $p_r$ sowie der freien Lösungsenthalpie von Sauerstoff in Siliciumschmelze $\Delta G^0$. $U_S$ und T werden gemessen, alle anderen Werte sind aus der Literatur bekannt oder durch individuelle Messungen unter Verwendung bekannter Meßtechniken zu ermitteln.

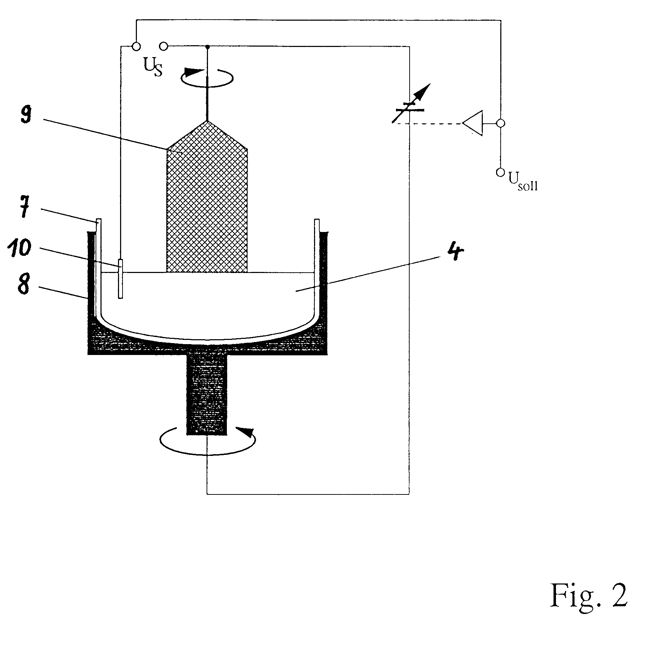

Die sauerstoffleitende Eigenschaft von $SiO_2$-Glas wird auch für den die Regelung der Sauerstoffkonzentration betreffenden Teil der vorliegenden Erfindung ausgenützt und in Fig. 2 am Beispiel des Czochralski-Verfahrens beschrieben. In diesem Fall dient der die Siliciumschmelze 4 enthaltende $SiO_2$-Glastiegel 7 als aktiver Sauerstoffionenleiter, indem eine ausreichend hohe Spannung zwischen Tiegelhalter 8 und wachsendem Kristall 9 angelegt wird. Die Stromdichte j an der Grenzfläche Tiegel/Schmelze sollte für eine effektive Verminderung des Sauerstoffgehalts in der Schmelze die chemische Auflösung des Tiegels 7 zumindest kompensieren. Unter der Annahme eines typischen chemischen Abtrags von ca. 1o µm/h ergibt sich $j \geqq 4$ mA/cm. Die oben beschriebene Sonde 1o läßt sich mit dieser Steuerung des Sauerstoffgehalts zu einem Regelkreis verbinden; die Steuerung kann jedoch auch allein betrieben werden.

Diese Regelung ist neben dem Czochralski-Verfahren für alle Verfahren einsetzbar, bei denen sich die Siliciumschmelze mit einer $SiO_2$-Glasoberfläche kontaktieren läßt.

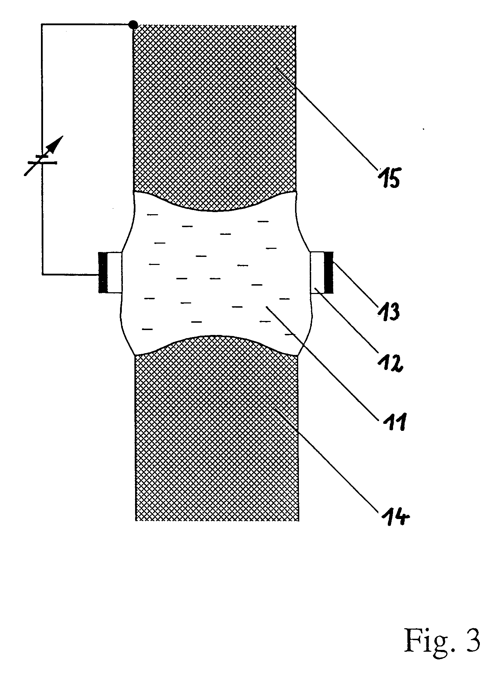

Als weiteres Beispiel zeigt Fig. 3 eine Möglichkeit, beim tiegelfreien Zonenziehen von Silicium den Sauerstoffgehalt in der Schmelzzone 11 durch Kontaktierung dieser Zone mit einem Ring 12 aus $SiO_2$-Glas zu steuern, indem man eine Steuerspannung zwischen einem äußeren Kontakt 13 und dem wachsenden Kristall 14 bzw. dem Vorrat 15 anlegt.

Das nachfolgende Beispiel demonstriert die Möglichkeit der Messung der Sauerstoffkonzentration mittels der beschriebenen Sonde; gleichzeitig wird hiermit die sauerstoffleitende Eigenschaft von $SiO_2$-Glas bei hohen Temperaturen gezeigt, da diese Eigenschaft Grundvoraussetzung der Konzentrationsmessung ist:

15o g Silicium wurden in einem $SiO_2$-Glastiegel unter 1 bar Argondruck aufgeschmolzen (Temperatur der Schmelze: 151o°C). Eine Sonde 1o gemäß Fig. 1 wurde eingetaucht; als Referenzgemisch wurde Mn/MnO verwendet. Nach ca. 2o s stellt sich eine Sondenspannung von ca. 9o mV ein. Bei der vorliegenden Temperatur gilt für das verwendete Referenzgemisch $p_r = 2{,}3$ $lo^{-15}$. Die freie Lösungsenthalpie $\Delta G^0$ wurde mittels eigener Experimente zu -118 kJ/mol bestimmt. Somit ergibt sich unter Verwendung der oben angegebenen Formel $n_O \approx 42$ ppm. Dies entspricht etwa der Löslichkeit von Sauerstoff in Siliciumschmelze, was zu erwarten war, da sich die Schmelze im Gleichgewicht mit festem $SiO_2$ befand.

## Patentansprüche

1. Verfahren zur Messung und Steuerung bzw. Regelung der Sauerstoffkonzentration in Siliciumschmelzen, welche sich in einem $SiO_2$-Glastiegel befinden oder mit einer $SiO_2$-Glasoberfläche in Kontakt bringbar sind, dadurch gekennzeichnet, daß die Messung der Sauerstoffkonzentration durch eine in die Schmelze eintauchende elektrochemische Potentialsonde erfolgt, wobei das Potential zwischen dem wachsenden Siliciumkristall und der Sonde abgegriffen wird.

2. Verfahren nach Anspruch 1, dadurch gekennzeichnet, daß eine Steuerung der Sauerstoffkonzentration durch Anlegen einer Steuerspannung zwischen dem außen kontaktierten $SiO_2$-Glastiegel bzw. einem außen kontaktierten, die Schmelze berührenden $SiO_2$-Glas und dem wachsenden Siliciumkristall bewerkstelligt wird.

3. Verfahren nach Anspruch 2, dadurch gekennzeichnet, daß der Sauerstoffgehalt der Schmelze bzw. des wachsenden Kristalls dadurch geregelt wird, daß das Potential zwischen dem wachsenden Siliciumkristall der Sonde gemessen und mit einem der gewünschten Sauerstoffkonzentration entsprechenden Referenz-Potentialwert verglichen wird, und daß bei Abweichungen von dem Referenzwert eine Korrektur durch Anlegen einer Steuerspannung zur Beeinflussung des Sauerstoff-Potentials vorgenommen wird.

4. Vorrichtung, insbesondere zur Durchführung des Verfahrens nach einem der Ansprüche 1 bis 3, dadurch gekennzeichnet, daß eine elektrochemische Potential-Sonde (1o) aus einem ein Metall/Metalloxid-Gemisch einschließenden, abgeschlossenen $SiO_2$-Glasröhrchen (1) gebildet ist, welches mit einem Metalldraht (3) kontaktiert ist.

Fig. 1

Fig. 2

Fig. 3